# FASCICULE DE BREVET EUROPEEN

(11) **EP 2 936 575 B1**
(45) Date de publication et mention de la délivrance du brevet: **04.11.2020**
(21) Numéro de dépôt: 13821847.4
(22) Date de dépôt: 17.12.2013
(51) Int. Cl.: B06B 1/06, G06F 3/01, G10K 9/12, H01L 41/047, H01L 41/053, H01L 41/25, H02N 2/04

(54) **ACTIONNEUR PIEZO-ELECTRIQUE ET PROCEDE DE FABRICATION ASSOCIE**
PIEZOELEKTRISCHER AKTUATOR UND ZUGEHÖRIGES HERSTELLUNGSVERFAHREN
PIEZOELECTRIC ACTUATOR AND ASSOCIATED FABRICATION PROCESS

(30) Priorité: 20.12.2012 FR 1203499
(43) Date de publication de la demande: 28.10.2015
(73) Titulaire: DAV, 94046 Créteil Cedex (FR)
(72) Inventeur: VANHELLE, Stéphane, 94046 Créteil Cedex (FR); AUBRY, Anthony, 94046 Créteil Cedex (FR)
(74) Mandataire: Pothmann, Karsten
(86) Numéro de dépôt international: PCT/FR2013/000344
(87) Numéro de publication internationale: WO 2014/096565

(56) Documents cités:
- WO-A1-97/22154
- DE-A1- 4 135 408
- JP-A- S6 142 284
- JP-A- H06 310 771
- KR-B1- 101 171 163
- US-A1- 2008 100 177
- US-A1- 2009 135 142
- US-A1- 2009 303 839

## Description

La présente invention concerne un actionneur piézo-électrique. Ledit actionneur piézo-électrique est destiné à produire des vibrations pour, par exemple, créer un retour haptique sur des interfaces tactiles. Ces interfaces tactiles sont, par exemple, des capteurs de touché résistifs, capacitifs ou optiques couplés à un écran d'affichage qui ne permettent pas d'avoir un ressenti tactile lors de la validation d'une commande comme un bouton classique. Il apparaît donc nécessaire d'introduire un retour haptique pour permettre ce retour (« feedback » en anglais) tactile.

Il est connu dans l'état de la technique d'utiliser des actionneurs piézo-électriques pour produire un tel retour haptique.

Par ailleurs, il est également connu d'amplifier les vibrations obtenues par un actionneur piézo-électrique en utilisant une structure métallique de forme elliptique.

Cependant, les structures métalliques proposées dans l'état de la technique sont obtenues à partir d'un bloc de matière métallique que l'on vient usiner. L'actionneur piézo-électrique étant ensuite calé et le câble d'alimentation de l'actionneur étant soudé manuellement et gainé pour limiter les contraintes au niveau de la soudure. Un tel procédé de fabrication est très couteux et demande beaucoup de manutention de sorte que les actionneurs de l'état de la technique sont inadaptés à la production en grande série et sont donc inappropriés pour les secteurs tels que le secteur automobile dans lesquels les cadences de production sont très importantes et où les coûts de fabrication doivent être réduits au maximum.

La présente invention vise donc à surmonter au moins partiellement les inconvénients précités de l'état de la technique et à proposer un actionneur permettant un retour haptique et qui est plus simple et moins cher à fabriquer que les actionneurs de l'état de la technique.

Des actionneurs connus sont décrits par DE 41 35 408 A1, US 2009 / 0303839 A1, JP 6-310771, WO 97 / 22154 A1, KR 10-1171163 B1, US 2008 / 0100177 A1, US 2009 / 0135142 A1 et JP 61-42284.

A cet effet, la présente invention concerne un actionneur piézo-électrique tel que défini par la revendication 1.

Un tel actionneur permet de réduire le coût matière et d'augmenter les cadences de production, notamment du à l'absence d'usinage, et par conséquent de réduire les coûts de production.

Selon un autre aspect de la présente invention, les extrémités de la, au moins, une feuille métallique sont fixées par soudage électrique ce qui permet de garantir la résistance de la structure métallique dans le temps par rapport aux vibrations.

Selon un aspect supplémentaire, la structure métallique oblongue a une forme sensiblement rhombique qui est obtenue par des pliages simples.

Selon un aspect additionnel, la structure métallique oblongue a une forme sensiblement elliptique.

Selon un autre aspect, la structure métallique est réalisée en tôle ce qui permet de réduire le coût matière.

Selon un aspect supplémentaire, la structure métallique comprend deux méplats parallèles entre eux et à l'élément piézoactif et centrés par rapport au grand axe de la structure métallique, les méplats facilitant la fixation de l'actionneur et permettant de contrôler l'orientation des vibrations.

Selon un aspect additionnel, les méplats sont bordés par des emboutis destinés à rigidifier la structure métallique

Selon un autre aspect, un surmoulage plastique est réalisé au niveau des méplats pour faciliter la fixation de l'actionneur.

Selon un aspect supplémentaire, un surmoulage plastique est réalisé au niveau des extrémités de la structure métallique au niveau du grand axe pour permettre la fixation de l'élément piézoactif sur la structure métallique et l'application de la précontrainte par la structure sur l'élément piézoactif.

Selon un aspect additionnel, l'actionneur piézo-électrique comprend un câble d'alimentation de l'élément piézoactif et un passage de câble destiné à recevoir ledit câble d'alimentation est réalisé dans un surmoulage de la structure métallique, ledit passage de câble comprenant une chicane de retenue du câble d'alimentation qui permet d'éviter un arrachement du câble au niveau de la soudure avec l'élément piézoactif et de se passer d'une gaine fastidieuse à installer. La suppression de la gaine permettant de réduire la main d'oeuvre nécessaire à la fabrication de l'actionneur et d'augmenter les cadences de fabrication.

Selon un autre aspect, le surmoulage plastique comprend un connecteur auquel est relié le câble d'alimentation de l'élément piézoactif ce qui permet d'inclure le connecteur à l'actionneur pour un coût réduit.

Selon un aspect supplémentaire, le surmoulage est réalisé en élastomère thermoplastique polyester ce qui permet d'obtenir un surmoulage souple et ayant une durée de vie importante.

Selon un aspect additionnel, l'élément piézoactif est une céramique piézo-électrique.

La présente invention concerne également un procédé de fabrication d'un actionneur piézo-électrique tel que défini par la revendication 13.

Selon un autre aspect, le procédé comprend également, avant l'étape de pliage, une étape d'emboutissage de la, au moins une, feuille métallique, ladite, au moins une, feuille métallique étant alors pliée de manière à former deux méplats parallèles entre eux et au grand axe de la structure métallique et centrés par rapport au grand axe de la structure métallique, lesdits méplats étant bordés par des emboutis pour rigidifier la structure métallique.

Selon un aspect additionnel, le procédé comprend, après l'étape de soudure, une étape de surmoulage plastique au niveau des méplats et au niveau des extrémités de la structure métallique se trouvant au niveau du grand axe pour permettre la fixation et la précontrainte de l'élément piézoactif.

Selon un aspect supplémentaire, l'étape d'assemblage comprend une soudure électrique des deux extrémités de la, au moins une, feuille métallique .

D'autres caractéristiques et avantages de la présente invention apparaîtront de la description qui va maintenant en être faite, en référence aux dessins annexés qui en représentent, à titre indicatif mais non limitatif des modes de réalisation possibles.

Sur ces dessins :
- la figure 1 représente une vue de côté en perspective d'un actionneur selon un premier mode de réalisation de la présente invention ;
- la figure 2 représente un schéma d'une feuille métallique destinée à former la structure métallique ;
- la figure 3 représente une vue en coupe d'un actionneur comprenant des surmoulage selon un deuxième mode de réalisation de la présente invention ;
- la figure 4 représente un actionneur comprenant un surmoulage dans lequel est inséré un passage de câble et un connecteur ;
- la figure 5 représente une vue de côté d'une structure métallique formée par deux feuilles métalliques soudées entre elles selon un troisième mode de réalisation de la présente invention ;
- la figure 6 représente un actionneur dont la structure métallique est formée par deux feuilles métalliques assemblées entre elles par des surmoulages selon un quatrième mode de réalisation de la présente invention ;
- la figure 7 représente un organigramme des différentes étapes du procédé de fabrication d'un actionneur selon les modes de réalisation de la présente invention.

Sur ces figures, les éléments ayant une fonction identique portent les même numéros de référence.

Le terme «tôle» définit une fine feuille de métal obtenue par laminage.

Le terme « élément piézoactif » définit un élément qui peut produire des mouvements ou vibrations lorsqu'il est alimenté par un champ électrique.

La présente invention concerne un actionneur piézo-électrique comprenant un élément piézoactif destiné à produire des vibrations et une structure métallique destinée à amplifier les vibrations produites par l'élément piézoactif.

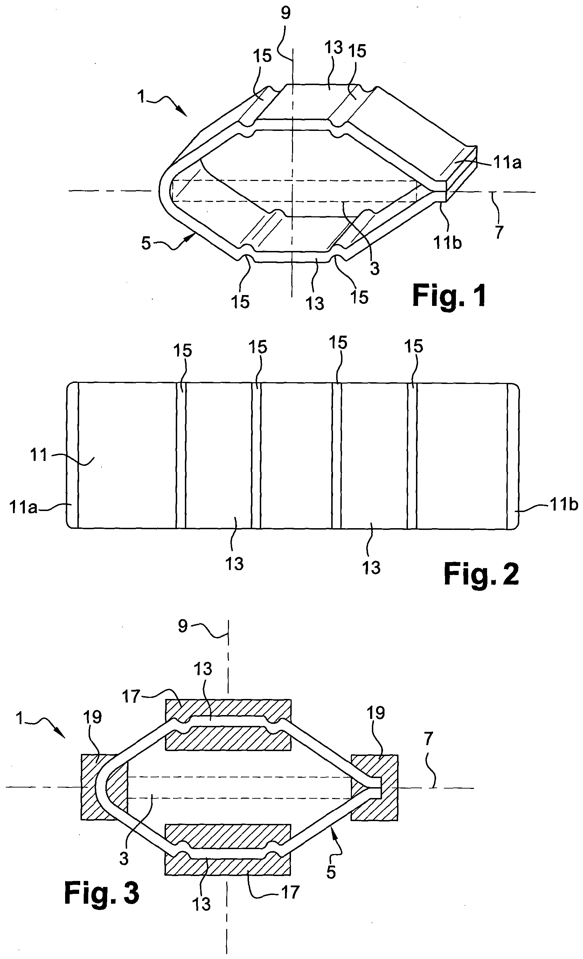

La figure 1 représente une vue de côté en perspective d'un actionneur 1 et en particulier de la structure métallique 5 selon un mode de réalisation de la présente invention. La structure métallique 5 est de forme oblongue qui définit un grand axe 7 et un petit axe 9, les deux axes 7 et 9 s'étendant perpendiculairement l'un par rapport à l'autre et entourant l'élément piézoactif 3 représenté ici en pointillés. La structure métallique 5 est obtenue par pliage d'une feuille métallique 11, comme par exemple une tôle, telle que représenté sur la figure 2. La feuille métallique 11 est prédécoupée aux dimensions voulues et est ensuite assemblée à ses extrémités 11a et 11b, par exemple par soudage électrique. Les différentes étapes du procédé de fabrication de la structure métallique 5 à partir de la feuille métallique 11 seront décrites en détails dans la suite de la description.

Ainsi, l'élément piézoactif 3, par exemple une céramique piézo-électrique, est disposé selon le grand axe 7 de la structure métallique 5 et est précontraint par ladite structure métallique 5. Les vibrations produites par l'élément piézoactif 3 selon le grand axe 7 de la structure métallique 5 sont donc transmises et amplifiées par la structure métallique 5 selon le petit axe 9 de ladite structure métallique 5. Les vibrations étant produites lorsque l'élément piézoactif 3 est alimenté, c'est à dire lorsqu'une tension est appliquée aux bornes de l'élément piézoactif 3 par application de l'effet piézo-électrique inverse. L'élément piézoactif 3 présente par exemple la forme d'une poutre métallique dans laquelle est insérée la céramique piézo-électrique.

De plus, l'alimentation de l'élément piézoactif 3 est réalisée par des câbles d'alimentation soudés aux bornes de la céramique piézo-électrique, les câbles étant reliés par ailleurs à une source d'alimentation. Par simplicité, dans la suite de la description, on parlera d'un câble d'alimentation même si celui-ci comprend en réalité deux câbles reliés à chaque borne de la céramique.

La forme oblongue de la structure métallique 5 peut être une forme sensiblement élliptique ou bien une forme rhombique ou en losange de manière à être obtenue facilement par pliage. De plus, afin de pouvoir contrôler l'orientation des vibrations émises par l'actionneur 1, la structure métallique 5 comprend deux méplats 13 au niveau du petit axe 9 de la structure 5. Les deux méplats 13 sont parallèles entre eux et à l'élément piézoactif 3 et centrés par rapport au grand axe 7 de la structure métallique 5. Ainsi, l'actionneur 1 peut être fixé au niveau d'un premier méplat 13 à une structure fixe et créer des vibrations sur une structure mobile fixée au deuxième méplat 13, les vibrations créées se propageant alors selon une direction perpendiculaire aux méplats 13.

De plus, afin de rigidifier la structure métallique 5, quatre emboutis 15 sont formés au niveau des zones de pliage correspondant aux bords des méplats 13, les emboutis 15 étant transversaux par rapport à la feuille métallique 11 comme représenté sur la figure 2. De plus, les extrémités 11a et 11b de la feuille métallique 11 peuvent également être embouties pour faciliter leur assemblage comme par exemple leur soudure.

L'actionneur 1 peut également comprendre des surmoulages 17 et 19 en plastiques disposés sur la structure métallique 5 afin d'améliorer les qualités mécaniques de la structure 5, notamment en la rigidifiant. Ces surmoulages 17 et 19 sont disposés au niveau des méplats 13 ainsi qu'aux extrémités de la structure 5 suivant le grand axe 7 comme représenté sur la figure 3. Les surmoulages 17 au niveau des méplats 13 permettent également de faciliter la fixation de l'actionneur 1 sur une structure fixe d'une part et sur la structure à laquelle on veut transmettre des vibrations d'autre part. Les surmoulages 19 au niveau des extrémités de la structure 5 suivant le grand axe 7 permettent de fixer et de contraindre l'élément piézoactif 3. Les surmoulages 17 et 19 sont réalisés par exemple en élastomère thermoplastique polyester tel que le Hytrel® pour accroitre leur flexibilité et leur durée de vie. De plus, un surmoulage peut également être utilisé pour assembler les extrémités 11a et 11b en remplacement de la soudure décrite précédemment.

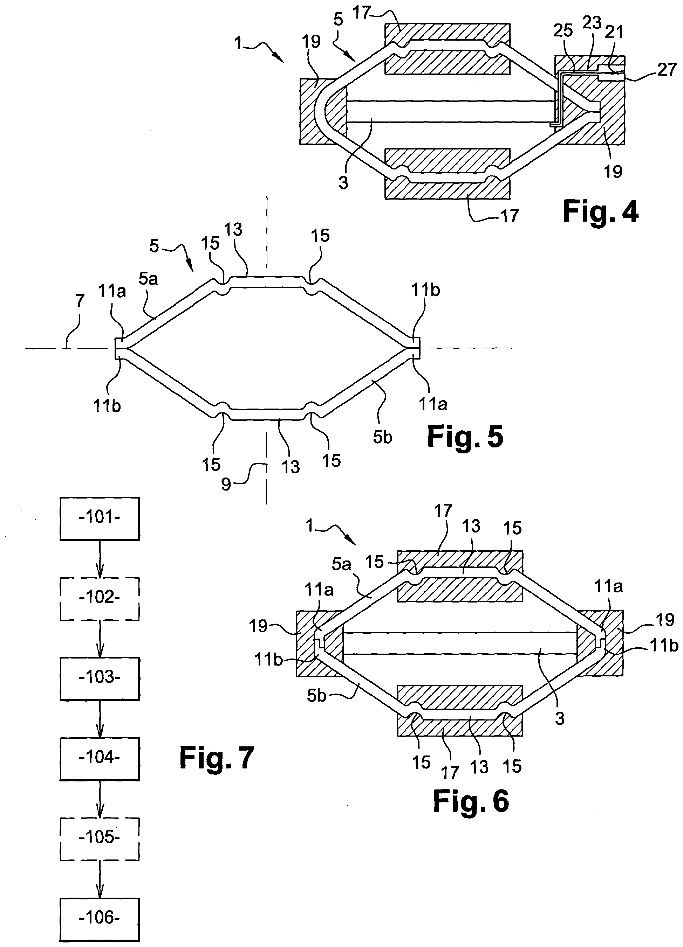

Par ailleurs, selon un mode de réalisation présenté sur la figure 4, l'un des surmoulages 19 au niveau des extrémités de la structure 5 suivant le grand axe 7 comprend un passage de câble 23 traversant le surmoulage 19 et destiné à recevoir le câble d'alimentation 21 de l'élément piézoactif 3. Le passage de câble 23 comprend par exemple une chicane 25 qui vise à empêcher un glissement du câble 21. En effet, un glissement du câble 21 pourrait entraîner des contraintes au niveau de la soudure du câble d'alimentation 21 sur l'élément piézoactif 3 allant jusqu'à une dégradation de la soudure et donc un dysfonctionnement de l'actionneur 1. D'autres moyens de prévention du glissement du câble 21 peuvent également être utilisé en alternative ou en complément à la chicane 25 comme une zone de rétrécissement du passage de câble 23 qui viendrait pincer légèrement le câble 21 pour le maintenir en position.

Le surmoulage 19 comprenant le passage de câble 23 peut également comprendre un connecteur 27 relié au câble d'alimentation. Le connecteur 27 étant un connecteur standard sur lequel on vient brancher un câble standard d'alimentation. Il est à noter que le surmoulage 19 peut comprendre un connecteur 27 sans avoir une chicane 25 au niveau de son passage de câble 23.

Selon un mode de réalisation alternatif, la structure métallique 5 peut être réalisée à partir de plusieurs feuilles métalliques 11, les différentes feuilles métalliques 11 étant pliées et assemblées pour obtenir la forme oblongue désirée pour la structure 5.

La figure 5 représente un exemple de réalisation d'une structure métallique 5 comprenant une première 5a et une deuxième 5b parties obtenues à partir d'une première et d'une deuxième feuilles métalliques 11, les deux feuilles métalliques 11 étant pliées pour obtenir la forme oblongue désirée. La première extrémité 11a de la première partie 5a est soudée à la deuxième extrémité 11b de la deuxième partie 5b et vice versa. Les soudures sont par exemple des soudures électriques. Les deux parties 5a et 5b comprennent une partie plane formant un méplat 13 bordée par des emboutis 15 délimitant le méplat 13. La structure métallique 5 obtenue a alors une forme similaire à la forme obtenue avec une seule feuille métallique 11 sur la figure 1.

De la même manière qu'avec une seule feuille métallique 11, des surmoulages 17 et 19 peuvent être ajoutés au niveau des méplats 13 et autour des soudures au niveau des extrémités 11a et 11b. Ces surmoulages peuvent également remplacer les soudures et permettre l'assemblage entre les deux feuilles métalliques 11a et 11b.

Selon un mode de réalisation alternatif représenté sur la figure 6, les deux demi-structures métalliques 5a et 5b sont seulement liées par coopération de forme au niveau de leur extrémités 11a et 11b respectives. Les deux demi-structures métalliques 5a et 5b sont par exemple posées, clipsées ou emboîtées l'une sur l'autre ou l'une dans l'autre au niveau de leurs extrémités 11a et 11b. La liaison mécanique obtenue par coopération de forme est alors renforcée par des surmoulages 19 qui assurent une rigidité suffisante à la liaison entre les deux demi-structures métalliques 5a et 5b.

De manière alternative ou complémentaire aux surmoulages, la liaison mécanique peut également être renforcée par collage.

Par ailleurs, comme pour les autres modes de réalisation, les feuilles métalliques peuvent formées des méplats 13 parallèles au grand axe 7 et centrés par rapport à leur longueur, les méplats 13 peuvent être bordés par des emboutis 15 transversaux et peuvent être surmoulés. Les surmoulages 17 servent alors à la fixation de l'actionneur 1 sur son support et sur la structure dans laquelle on veut propager des vibrations tandis que les surmoulages 19 servent à la fixation et la précontrainte de l'élément piézoactif 3 sur la structure métallique 5 formée par l'assemblage des deux demi-structures métalliques 5a et 5b. Un passage de câble 23, notamment un passage de câble 23 comprenant une chicane 25 et un connecteur 27 peuvent évidemment être insérés dans un des surmoulages 19 du mode de réalisation de l'actionneur 1 présenté sur la figure 6.

Les différentes étapes de fabrication d'un actionneur 1 selon la présente invention vont maintenant être décrites à partir de l'organigramme de la figure 7. Sur cet organigramme, les étapes représentées en pointillés correspondent à des étapes facultatives de la fabrication qui ne servent que pour certains modes de réalisation particuliers.

La première étape 101 correspond au découpage d'une feuille métallique 11, notamment une tôle, à une taille prédéterminée. La taille prédéterminée dépend de la taille de l'actionneur 1 que l'on veut réaliser et en particulier de la taille de l'élément piézoactif 3 ainsi que du nombre de feuilles métalliques 11 utilisées pour former la structure métallique 5.

La deuxième étape 102 qui est facultative correspond à une étape d'emboutissage destinée à créer des emboutis 15 transversaux sur la feuille métallique 11. Ces emboutis 15 sont réalisés aux endroits correspondant aux bords des futurs méplats 13 et/ou aux extrémités 11a et 11b de la feuille métallique 11. Sur la figure2, la feuille métallique 11 comprend quatre emboutis 15 au niveau des bords des futurs méplats 13.

La troisième étape 103 correspond au pliage de la feuille métallique 11 obtenue à l'étape 101 ou 102 pour obtenir la forme désirée pour la structure métallique 5. Le pliage est par exemple réalisée de manière automatique par une machine de pliage. La feuille métallique 11 étant fine, son pliage ne nécessite pas de chauffer la feuille métallique 5 ce qui facilite sa fabrication. Le pliage permet d'obtenir une structure métallique 5 ayant une forme oblongue sensiblement elliptique ou sensiblement rhombique, l'ellipse ou le losange pouvant être aplatis sur les sommets du petit axe pour former les méplats 13. Pour cela, les parties correspondant aux méplats 13 ne sont pas pliées, par exemple en étant maintenues entre deux plaques parallèles. Dans le cas où l'on a deux feuilles métalliques 11a et 11b, les deux feuilles métalliques 11a et 11b sont pliées de manière identique de sorte qu'une seule machine de pliage peut être utilisée pour réaliser le pliage des deux feuilles métalliques 11a et 11b.

La quatrième étape 104 correspond à l'assemblage des extrémités 11a et 11b de la feuille métallique 11, les extrémités 11a et 11b étant assemblées entre elles dans le cas d'une feuille métallique 11 unique ou assemblées aux extrémités de l'autre feuille 11 dans le cas ou la structure métallique 5 est formée à partir de deux feuilles métalliques 11. L'assemblage des deux feuilles 11 peut comprendre un emboitement ou encastrement de leurs extrémités qui ont des formes complémentaires, une soudure entre leurs extrémités, par exemple une soudure électrique ou un collage. L'assemblage permet ainsi d'obtenir la forme oblongue désirée pour la structure métallique 5. L'assemblage entre les feuilles métalliques peut également être réalisé par surmoulage. Dans ce cas, la ou les feuilles métalliques 11 sont placées dans un moule dans lequel on vient appliquer le surmoulage.

La cinquième étape 105 qui est une étape facultative correspond à une étape de surmoulage plastique de certaines zones de la structure métallique 5 en particulier les éventuels méplats 13 et les extrémités de la structure métallique selon le grand axe 7. Ces surmoulages 17 et 19 visent à rigidifier la structure 5 et favoriser la fixation de l'élément piézoactif 3 sur la structure métallique 5 ou de la structure métallique 5 sur une support ou une autre structure. Ces surmoulages 17 et 19 sont réalisés par exemple en polyuréthane ou en élastomère thermoplastique polyester. De plus, l'un des surmoulages 19 peut être réalisé avec un passage de câble 23 et /ou un connecteur 27 pour faciliter l'alimentation de l'élément piézoactif 3.

La sixième étape 106 correspond à une étape de fixation de l'élément piézoactif 3 sur la structure 5 obtenue à l'étape 104 ou 105. L'élément piézoactif 3 est inséré selon le grand axe 7 de la structure 5 et est par exemple monté en force pour être précontraint par la structure 5. Si la structure 5 comprend des surmoulages 19 aux niveau de ses extrémités, l'élément piézoactif 3 est inséré et précontraint entre ces surmoulages 19. De plus si l'un des surmoulages 19 comprend un passage de câble, l'étape 106 comprend le positionnement du câble 21 dans le passage de câble 23.

Ainsi, la présente invention permet, grâce à un pliage d'au moins une feuille métallique 11, d'obtenir de manière simple et peu coûteuse une structure métallique 5 de forme oblongue et ainsi de permettre la fabrication pour un coût réduit d'un actionneur piézoélectrique amplifié 1. En effet, par rapport aux solutions de l'état de la technique, l'utilisation de tôles pliées permet non seulement de réduire le coût matière mais également de simplifier le procédé de fabrication d'un actionneur piézo-électrique destiné à produire une retour haptique, par exemple pour un module de commande.

## Revendications

1. Actionneur piézo-électrique (1) comprenant :
- un élément piézoactif (3) destiné à produire des vibrations et,
- une structure métallique oblongue (5) comprenant un grand axe (7) et un petit axe (9) s'étendant perpendiculairement l'un par rapport à l'autre et entourant l'élément piézoactif (3) qui est disposé selon le grand axe (7) de la structure métallique (5), ladite structure métallique (5) étant configurée pour précontraindre l'élément piézoactif (3) et pour amplifier, selon le petit axe (9) de la structure métallique (5), les vibrations produites par l'élément piézoactif (3),
**caractérisé en ce que** la structure métallique oblongue (5) étant une feuille métallique prédécoupée et pliée (11) et dans lequel les extrémités (11a et 11b) de la feuille métallique (11) sont assemblées par soudage électrique pour obtenir la structure métallique oblongue.

2. Actionneur piézo-électrique (1) selon la revendication 1 dans lequel la structure métallique oblongue (5) a une forme sensiblement rhombique.

3. Actionneur piézo-électrique (1) selon la revendication 1 dans lequel la structure métallique oblongue (5) a une forme sensiblement elliptique.

4. Actionneur piézo-électrique (1) selon l'une des revendications précédentes dans lequel la structure métallique (5) est réalisée en tôle.

5. Actionneur piézo-électrique (1) selon l'une des revendications précédentes dans lequel la structure métallique (5) comprend deux méplats (13) parallèles entre eux et à l'élément piézoactif (3) et centrés par rapport au grand axe (7) de la structure métallique (5).

6. Actionneur piézo-électrique (1) selon la revendication 5 dans lequel les méplats (13) sont bordés par des emboutis (15) destinés à rigidifier la structure métallique (5).

7. Actionneur piézo-électrique (1) selon la revendication 5 ou 6 dans lequel un surmoulage plastique (17) est réalisé au niveau des méplats (13) pour permettre la fixation de l'actionneur (1).

8. Actionneur piézo-électrique (1) selon l'une des revendications précédentes dans lequel un surmoulage plastique (19) est réalisé au niveau des extrémités de la structure métallique (5) au niveau du grand axe (7) pour permettre la fixation de l'élément piézoactif (3).

9. Actionneur piézo-électrique (1) selon la revendication 8 comprenant un câble d'alimentation (21) de l'élément piézoactif (3) et dans lequel un surmoulage plastique (19) comprend un passage de câble (23) destiné à recevoir ledit câble d'alimentation (21), ledit passage de câble comprenant une chicane (25) de retenue du câble d'alimentation (21).

10. Actionneur piézo-électrique (1) selon la revendication 9 dans lequel le surmoulage plastique (19) comprend un connecteur (27) auquel est relié le câble d'alimentation (21) de l'élément piézoactif (3).

11. Actionneur piézo-électrique (1) selon l'une des revendications 7 à 10 dans lequel le surmoulage (17, 19) est réalisé en élastomère thermoplastique polyester.

12. Actionneur piézo-électrique (1) selon l'une des revendications précédentes dans lequel l'élément piézoactif (3) est une céramique piézo-électrique.

13. Procédé de fabrication d'un actionneur piézo-électrique (1) dans lequel :
- on découpe (101) une feuille métallique (11),
- on plie (103) la feuille métallique (11) découpée pour former une structure métallique oblongue (5) comprenant un grand axe (7) et un petit axe (9) s'étendant perpendiculairement l'un par rapport à l'autre,
- on assemble (104) les deux extrémités (11a et 11b) de la feuille métallique (11) pliée pour obtenir la structure métallique oblongue (5),
- on fixe (106) un élément piézoactif (3) selon le grand axe (9) de la structure métallique oblongue (5), ledit élément piézoactif (3) étant précontraint par la structure métallique oblongue (5).

14. Procédé de fabrication d'un actionneur piézo-électrique (1) selon la revendication 13 comprenant également, avant l'étape de pliage (103), une étape d'emboutissage (102) de la feuille métallique (5), ladite feuille métallique (5) étant alors pliée de manière à former deux méplats (13) parallèles entre eux et au grand axe (7) de la structure métallique (5) et centrés par rapport au grand axe (7) de la structure métallique (5), lesdits méplats (13) étant bordés par des emboutis (15) pour rigidifier la structure métallique (5).

15. Procédé de fabrication d'un actionneur piézo-électrique (1) selon la revendication 13 ou 14 comprenant, après l'étape de soudure (104), une étape de surmoulage plastique (105) au niveau des méplats (13) et au niveau des extrémités de la structure métallique (5) se trouvant au niveau du grand axe (7) pour permettre la fixation et la précontrainte de l'élément piézoactif (3).

16. Procédé de fabrication d'un actionneur piézo-électrique (1) selon l'une des revendications 13 à 15 dans lequel l'étape d'assemblage 104 comprend une soudure électrique des deux extrémités de la feuille métallique .

## Patentansprüche

1. Piezoelektrischer Aktor (1), der enthält:
- ein piezoaktives Element (3), das dazu bestimmt ist, Schwingungen zu erzeugen, und
- eine längliche Metallstruktur (5), die eine große Achse (7) und eine kleine Achse (9) enthält, die sich lotrecht zueinander erstrecken und das piezoaktive Element (3) umgeben, das gemäß der großen Achse (7) der Metallstruktur (5) angeordnet ist, wobei die Metallstruktur (5) konfiguriert ist, das piezoaktive Element (3) vorzuspannen und die vom piezoaktiven Element (3) erzeugten Schwingungen gemäß der kleinen Achse (9) der Metallstruktur (5) zu verstärken,
**dadurch gekennzeichnet, dass** die längliche Metallstruktur (5) eine vorgeschnittene und umgebogene Metallfolie (11) ist, und wobei die Enden (11a und 11b) der Metallfolie (11) durch Elektroschweißen zusammengefügt werden, um die längliche Metallstruktur zu erhalten.

2. Piezoelektrischer Aktor (1) nach Anspruch 1, wobei die längliche Metallstruktur (5) eine im Wesentlichen rhombische Form hat.

3. Piezoelektrischer Aktor (1) nach Anspruch 1, wobei die längliche Metallstruktur (5) eine im Wesentlichen elliptische Form hat.

4. Piezoelektrischer Aktor (1) nach einem der vorhergehenden Ansprüche, wobei die Metallstruktur (5) aus Blech hergestellt ist.

5. Piezoelektrischer Aktor (1) nach einem der vorhergehenden Ansprüche, wobei die Metallstruktur (5) zwei zueinander und zum piezoaktiven Element (3) parallele und bezüglich der großen Achse (7) der Metallstruktur (5) zentrierte Abflachungen (13) enthält.

6. Piezoelektrischer Aktor (1) nach Anspruch 5, wobei die Abflachungen (13) von Tiefziehungen (15) umrandet sind, die dazu bestimmt sind, die Metallstruktur (5) zu versteifen.

7. Piezoelektrischer Aktor (1) nach Anspruch 5 oder 6, wobei eine plastische Umspritzung (17) im Bereich der Abflachungen (13) durchgeführt wird, um die Befestigung des Aktors (1) zu erlauben.

8. Piezoelektrischer Aktor (1) nach einem der vorhergehenden Ansprüche, wobei eine plastische Umspritzung (19) im Bereich der Enden der Metallstruktur (5) im Bereich der großen Achse (7) durchgeführt wird, um die Befestigung des piezoaktiven Elements (3) zu erlauben.

9. Piezoelektrischer Aktor (1) nach Anspruch 8, der ein Versorgungskabel (21) des piezoaktiven Elements (3) enthält, und wobei eine plastische Umspritzung (19) einen Kabeldurchlass (23) enthält, der dazu bestimmt ist, das Versorgungskabel (21) aufzunehmen, wobei der Kabeldurchlass eine Schikane (25) für den Halt des Versorgungskabels (21) enthält.

10. Piezoelektrischer Aktor (1) nach Anspruch 9, wobei die plastische Umspritzung (19) einen Verbinder (27) enthält, mit dem das Versorgungskabel (21) des piezoaktiven Elements (3) verbunden ist.

11. Piezoelektrischer Aktor (1) nach einem der Ansprüche 7 bis 10, wobei die Umspritzung (17, 19) mit thermoplastischem Polyesterelastomer erfolgt.

12. Piezoelektrischer Aktor (1) nach einem der vorhergehenden Ansprüche, wobei das piezoaktive Element (3) eine piezoelektrische Keramik ist.

13. Verfahren zur Herstellung eines piezoelektrischen Aktors (1), wobei:
- eine Metallfolie (11) ausgeschnitten wird (101),
- die ausgeschnittene Metallfolie (11) umgebogen wird (103), um eine längliche Metallstruktur (5) zu formen, die eine große Achse (7) und eine kleine Achse (9) enthält, die sich zueinander lotrecht erstrecken,
- die zwei Enden (11a und 11b) der umgebogenen Metallfolie (11) zusammengefügt werden (104), um die längliche Metallstruktur (5) zu erhalten,
- ein piezoaktives Element (3) gemäß der großen Achse (9) der länglichen Metallstruktur (5) befestigt wird (106), wobei das piezoaktive Element (3) durch die längliche Metallstruktur (5) vorgespannt wird.

14. Verfahren zur Herstellung eines piezoelektrischen Aktors (1) nach Anspruch 13, das ebenfalls vor dem Schritt des Umbiegens (103) einen Schritt des Tiefziehens (102) der Metallfolie (5) enthält, wobei die Metallfolie (5) dann so umgebogen wird, dass sie zwei zueinander und zur großen Achse (7) der Metallstruktur (5) parallele und bezüglich der großen Achse (7) der Metallstruktur (5) zentrierte Abflachungen (13) formt, wobei die Abflachungen (13) von Tiefziehungen (15) umrandet werden, um die Metallstruktur (5) zu versteifen.

15. Verfahren zur Herstellung eines piezoelektrischen Aktors (1) nach Anspruch 13 oder 14, das nach dem Schweißschritt (104) einen Schritt plastischer Umspritzung (105) im Bereich der Abflachungen (13) und im Bereich der Enden der Metallstruktur (5) enthält, die sich im Bereich der großen Achse (7) befinden, um die Befestigung und die Vorspannung des piezoaktiven Elements (3) zu erlauben.

16. Verfahren zur Herstellung eines piezoelektrischen Aktors (1) nach einem der Ansprüche 13 bis 15, wobei der Schritt des Zusammenfügens (104) ein Elektroschweißen der zwei Enden der Metallfolie enthält.

## Claims

1. Piezoelectric actuator (1) comprising:
- a piezoactive element (3) intended to produce vibrations, and
- an oblong metallic structure (5) comprising a major axis (7) and a minor axis (9) extending at right angles to one another and surrounding the piezoactive element (3) which is arranged on the major axis (7) of the metallic structure (5), the said metallic structure (5) being configured to preload the piezoactive element (3) and to amplify, along the minor axis (9) of the metallic structure (5), the vibrations produced by the piezoactive element (3),
**characterized in that** the oblong metallic structure (5) being a pre-cut and bent metal sheet (11) and one in which the ends (11a and 11b) of the metallic sheet (11) are assembled by electric welding in order to obtain the oblong metallic structure.

2. Piezoelectric actuator (1) according to Claim 1, wherein the oblong metallic structure (5) has a substantially rhomboid shape.

3. Piezoelectric actuator (1) according to Claim 1, wherein the oblong metallic structure (5) has a substantially elliptical shape.

4. Piezoelectric actuator (1) according to one of the preceding claims, wherein the metallic structure (5) is made of sheet metal.

5. Piezoelectric actuator (1) according to one of the preceding claims, wherein the metallic structure (5) comprises two flats (13) that are parallel to one another and to the piezoactive element (3) and centred with respect to the major axis (7) of the metallic structure (5).

6. Piezoelectric actuator (1) according to Claim 5, wherein the flats (13) are flanked by pressings (15) intended to stiffen the metallic structure (5).

7. Piezoelectric actuator (1) according to Claim 5 or 6, wherein a plastics overmoulding (17) is created at the flats (13) to allow the attachment of the actuator (1).

8. Piezoelectric actuator (1) according to one of the preceding claims, wherein a plastics overmoulding (19) is produced at the ends of the metallic structure (5) at the level of major axis (7) to allow the attachment of the piezoactive element (3).

9. Piezoelectric actuator (1) according to Claim 8, comprising a power supply cable (21) supplying to the piezoactive element (3) and wherein a plastics overmoulding (19) comprises a cable lead-through (23) intended to accommodate said power supply cable (21), said cable lead-through comprising a chicane (25) for retaining the power supply cable (21).

10. Piezoelectric actuator (1) according to Claim 9, wherein the plastics overmoulding (19) comprises a connector (27) to which the power supply cable (21) of the piezoactive element (3) is connected.

11. Piezoelectric actuator (1) according to one of Claims 7 to 10, wherein the overmoulding (17, 19) is made of a polyester thermoplastic elastomer.

12. Piezoelectric actuator (1) according to one of the preceding claims, wherein the piezoactive element (3) is a piezoelectric ceramic.

13. Method for manufacturing a piezoelectric actuator (1), wherein:
- a metallic sheet (11) is cut (101),
- the cut metallic sheet (11) is bent (103) to form an oblong metallic structure (5) comprising a major axis (7) and a minor axis (9) extending at right angles to one another,
- the two ends (11a and 11b) of the bent metallic sheet (11) are assembled (104) to obtain the oblong metallic structure (5),
- a piezoactive element (3) is attached (106) along a major axis (9) of the oblong metallic structure (5), said piezoactive element (3) being preloaded by the oblong metallic structure (5).

14. Method for manufacturing a piezoelectric actuator (1) according to Claim 13, also comprising, prior to the bending step (103), a step (102) of pressing the metallic sheet (5), said metallic sheet (5) then being bent in such a way as to form two flats (13) that are parallel to one another and to the major axis (7) of the metallic structure (5) and centred with respect to the major axis (7) of the metallic structure (5), said flats (13) being flanked by pressings (15) to stiffen the metallic structure (5) .

15. Method for manufacturing a piezoelectric actuator (1) according to Claim 13 or 14 comprising, after the welding step (104), a step (105) of overmoulding plastics on the flats (13) and on the ends of the metallic structure (5) which are situated on the major axis (7) so as to allow the attachment and preloading of the piezoactive element (3).

16. Method for manufacturing a piezoelectric actuator (1) according to one of Claims 13 to 15, wherein the assembly step (104) involves electrically welding the two ends of the metal sheet.
